# EUROPEAN PATENT SPECIFICATION

(11) **EP 0 342 873 B1**
(45) Date of publication and mention of the grant of the patent: **06.04.1994**
(21) Application number: 89304822.3
(22) Date of filing: 12.05.1989
(51) Int. Cl.: H01R 23/70

(54) **Surface mount connector**
Oberflächenmontierbarer Steckverbinder
Connecteur pour le montage sur une surface

(30) Priority: 17.05.1988 JP 118365/88
(43) Date of publication of application: 23.11.1989
(73) Proprietor: THOMAS & BETTS CORPORATION, Memphis, Tennessee 38119 (US)
(72) Inventor: Nakamura, Mituru, Isehara-shi Kanagawa Pref. (JP); Suzuki, Masao, Setagaya-ku Tokyo (JP)
(74) Representative: Howick, Nicholas Keith

(56) References cited:
- GB-A- 935 322
- US-A- 4 262 986
- IBM TECHNICAL DISCLOSURE BULLETIN. vol. 9, no. 2, July 1966, NEW YORK US pages 148 - 149; j.j.Shea: "Double contact connector"

## Description

The present invention relates to connectors, and more particulary but not exclusively to a low-profile (low height) connector primarily mounted on a printed circuit board.

In a conventional connector of this type, a housing is fixed on a printed circuit by a certain fixing means. US-A-4262986 discloses a surface mount connector to be used with a printed circuit board, the connector having two parts of different shape secured together by conventional fastening techniques and enclosing the edge of a printed circuit board, a plurality of contacts extending from one side surface of one housing part along a longitudinal direction thereof. The contacts have contact portions which are brought into contact with conductive patterns formed on the circuit board when the two parts are secured together. Alternatively, terminals extending from the housing are inserted in through holes formed in the printed circuit board in advance and are soldered, thereby mounting the connector on the surface of the printed circuit board. However, a required mounting area of the printed circuit board is increased, making it difficult to obtain a compact printed circuit board mounted with a connector. In addition, a low-profile printed circuit board mounted with a connector cannot be obtained due to the height of the connector.

It is an object of the present invention to provide a surface mount connector free from the conventional problems described above.

It is another object of the present invention to provide a low-profile surface mount connector mounted at a side edge of the printed circuit board to allow connection to another connecting member.

According to the present invention, there is provided a surface mount connector for engagement with a printed circuit board, which connector comprises a pair of elongate housings engageable with each other to form a channel for receiving, in use, an edge portion of a printed circuit board, and a plurality of contacts extending from one side surface of at least one of the housings along a longitudinal direction of said one side surface, said contacts having contact portions for contacting, in use, when the housings are engaged with each other, conductive portions on at least one surface of a printed circuit board, the housings comprising engaging portions constituted by a plurality of mating projections formed along the longitudinal direction of the housings.

Embodiments of connectors according to the present invention will now be described by way of example with reference to the accompanying drawings, in which:-
Figure 1 is a perspective view showing a state wherein a connector according to a first embodiment of the present invention is mounted on a printed circuit board;
Figure 2 is a front view showing a state wherein the connector shown in Figure 1 is mounted on the printed circuit board;
Figure 3 is a sectional view showing the state of Figure 2 along the line A-A thereof; and
Figures 4 and 5 show second and third embodiments of the presention invention, respectively, in which Figures 4A and 5A are sectional views showing states wherein connectors are mounted on printed circuit boards, and Figures 4B and 5B are sectional views showing the states of Figures 4A and 5A along the lines C-C thereof.

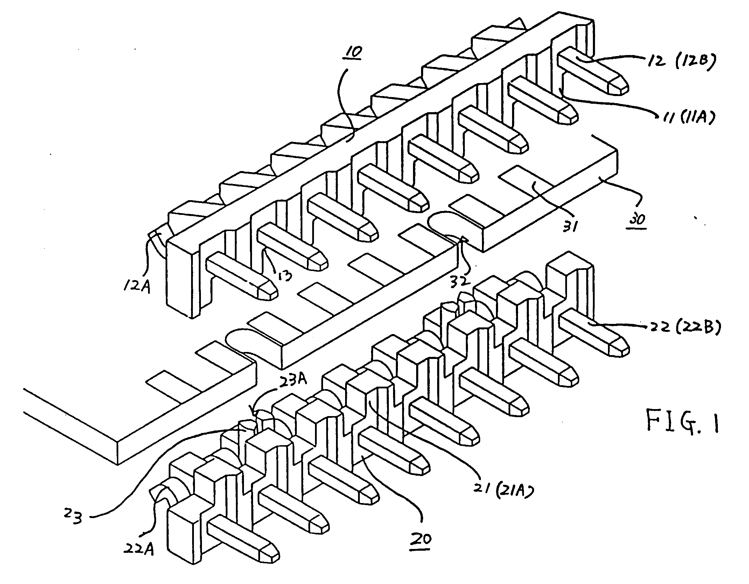

Referring to Figure 1, reference numerals 10 and 20 denote a pair of elongated housings having an identical shape. The pair of elongated housings 10 and 20 are engaged with each other through one side edge of a printed circuit board 30. In this embodiment, a plurality of mating projections 11A and 21A are formed on the housings 10 and 20 along their longitudinal direction, thereby constituting engaging portions 11 and 21.

Reference numerals 12 and 22 denote contacts extending from side surfaces of the housings at predetermined intervals along their longitudinal direction. The contacts extend through the corresponding housings and have contact portions 12A and 22A which are brought into contact with conductive patterns or electrodes 31 formed on the surface of the printed circuit board, and contact portions 12B and 22B which are connected to other connecting members when the pair of housings are engaged with each other.

The conductive patterns or the like which are brought into contact with the contacts may be formed on one or both surfaces of the printed circuit board.

In this embodiment, when the connector is mounted on the printed circuit board such that the printed circuit board is sandwiched by the housings of the connector, these portions of the engaged housings which are adjacent to the contact portions of the contacts sandwich the printed circuit board, and the engaging portions extend downward (when the housing is mounted on the upper surface of the printed circuit board) or upward (when the housing is mounted on the lower surface of the printed circuit board) from one side surface of the printed circuit board and are engaged with each other. Positions at which the contacts extend through the housings are above (when the housing is mounted on the upper surface of the printed circuit board) or below (when the housing is mounted on the lower surface of the printed circuit board) the engaging portions of the housings. In the illustrative embodiment, the contacts extending through the housings and the engaging portions of the housings are offset from each other in the longitudinal direction.

In the illustrative embodiment, when the pair of housings are engaged with each other through the printed circuit board, guides 13 and 23 which are engaged with each other extend from the opposite sides of the housings. Holes or notches 32 which receive the guides are formed in the printed circuit board.

In the embodiment shown in Fig. 1, at least one guide is a post having a split slot 23A and a cross section of a notched circle.

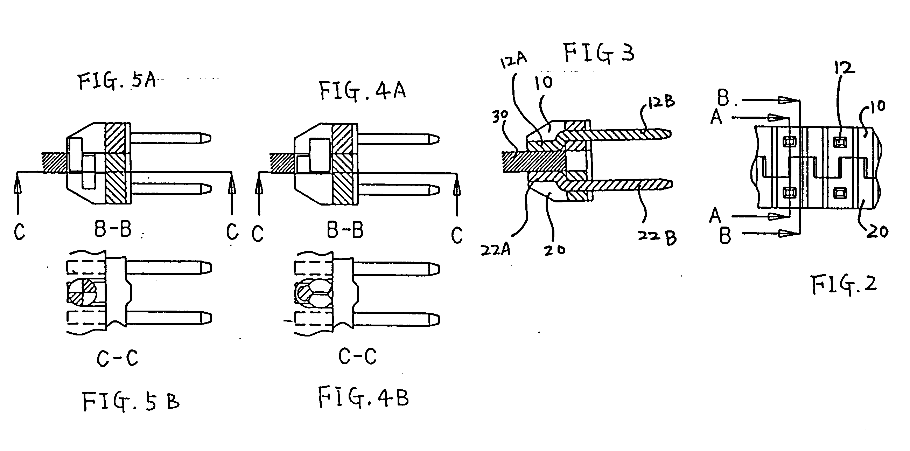

Fig. 2 is a front view showing a state wherein the connector according to the present invention is mounted on the printed circuit board. As is apparent from Fig. 2, the upper and lower housings are meshed with each other, and the contacts and the engaging portions of the housings are offset from each other and are located at positions of different levels.

Fig. 3 is a sectional view of Fig. 2 along the line A -A thereof. The housings are engaged with each other through the printed circuit board, and the contact portions of the contacts are in contact with the patterns of the printed circuit board.

Figs. 4 and 5 show second and third embodiments having guides having different cross sections. The front views showing the states wherein connectors are mounted on printed circuit boards are the same as that of Fig. 2, and cross sections along the line B - B of Fig. 2 are shown in Figs. 4A and 5A. Cross sections along the line C - C of Figs. 4A and 5A are shown in Figs. 4B and 5B.

The connector having the above structure according to the present invention has the following unique effect.

In the connector of the present invention, given portions of the housings of the connector sandwich the printed circuit board, and the remaining portions are meshed with each other. Therefore, the area required for the connector on the printed circuit board is small. At the same time, the engaging portions of the housings are vertically engaged outside the printed circuit board (i.e., without clamping the printed circuit board). Therefore, the height of the housings can be reduced accordingly, and an excellent effect as the low-profile connector can be obtained.

In addition, the connector of the present invention can be mounted on the upper surface of the printed circuit board, and the contacts do not scratch or cut preliminary soldered portions on the printed circuit board, thereby preventing incomplete contact caused by scratching or cutting of the preliminary soldered portions.

## Claims

1. A surface mount connector for engagement with a printed circuit board, which connector comprises a pair of elongate housings (10, 20) engageable with each other to form a channel for receiving, in use, an edge portion of a printed circuit board, and a plurality of contacts (12, 22) extending from one side surface of at least one of the housings (10, 20) along a longitudinal direction of said one side surface, said contacts (12, 22) having contact portions (12A, 22A) for contacting, in use, when the housings are engaged with each other, conductive portions on at least one surface of a printed circuit board, the housings (10, 20) comprising engaging portions (11, 21) constituted by a plurality of mating projections (11A, 21A) formed along the longitudinal direction of the housings (10, 20).

2. A surface mount connector according to Claim 1, characterised in that said pair of housings (10, 20) have an identical shape.

3. A surface mount connector according to Claim 1 or Claim 2, characterised in that said engaging portions (11, 21) of said housings and said contacts (12, 22) are offset from each other along the longitudinal direction of said housings and are located at positions of different levels.

4. A surface mount connector according to any one of Claims 1 to 3 characterised in that said contacts have connecting portions (12B and 22B) which extend through said housing and extend therefrom on a side opposite to said contact portions (12A, 22A) of said contacts (12, 22).

5. A surface mount connector according to any one of Claims 1 to 4, characterised in that said pair of housings comprises guides (13 and 23) extending from opposite sides of said housings so as to be engaged with each other.

6. A surface mount connector according to Claim 5, characterised in that at least one of said pair of guides to be engaged with each other comprises a post having a split slot (23A) and a cross section of a notched circle.

7. A surface mount connector as claimed in Claim 6 or Claim 7, assembled with a printed circuit board (30) having holes or notches (32) therein, wherein said guides (13, 23) are engaged with each other through said holes or notches (32).

8. A surface mount connector as claimed in any one of Claims 1 to 6, assembled with a printed circuit board (30), wherein portions of said housings (10, 20) adjacent to said contact portions (12A, 22A) of said contacts (12, 22) of each housing (10, 20) sandwich said printed circuit board, and said engaging portions (11, 21) extend in opposing directions from one side surface of said printed circuit board.

## Patentansprüche

1. Ein oberflächenmontierter Verbinder zur Anlage an eine Leiterplatte, der zwei unter Ausbildung eines Kanals zur Aufnahme eines Kantenabschnittes der Leiterplatte bei Gebrauch miteinander in Eingriff bringbare langgestreckte Gehäuse (10, 20) und eine Vielzahl von von einer Seitenfläche mindestens eines der Gehäuse (10, 20) entlang einer Längsrichtung der einen Seitenfläche ausgehenden Kontakten (12, 22) aufweist, die bei miteinander in Eingriff befindlichen Gehäusen bei Gebrauch Kontaktabschnitte (12A, 22A) zum Kontaktieren von leitenden Abschnitten auf mindestens einer Oberfläche einer Leiterplatte aufweisen, wobei die Gehäuse (10, 20) Kupplungsabschnitte (11, 21) aufweisen, die durch eine Vielzahl von entlang der Längsrichtung der Gehäuse (10, 20) ausgebildeten, zusammenpassenden Vorsprüngen (11A, 21A) gebildet sind.

2. Ein oberflächenmontierter Verbinder nach Anspruch 1, dadurch gekennzeichnet, daß die beiden Gehäuse (10, 20) eine identische Form aufweisen.

3. Ein oberflächenmontierter Verbinder nach Anspruch 1 oder Anspruch 2, dadurch gekennzeichnet, daß die Kupplungsabschnitte (11, 21) der Gehäuse und die Kontakte (12, 22) entlang der Längsachse der Gehäuse gegeneinander versetzt und an Stellen verschiedener Höhe angeordnet sind.

4. Ein oberflächenmontierter Verbinder nach irgendeinem der Ansprüche 1 bis 3, dadurch gekennzeichnet, daß die Kontakte verbindende Abschnitte (12B und 22B) aufweisen, die durch das Gehäuse durchtreten und von dort auf einer Seite gegenüber den Kontaktabschnitten (12A, 22A) der Kontakte (12, 22) verlaufen.

5. Ein oberflächenmontierter Verbinder nach irgendeinem der Ansprüche 1 bis 4, dadurch gekennzeichnet, daß die beiden Gehäuse von sich gegenüberliegenden Seiten der Gehäuse verlaufende Führungen (13 und 23) aufweisen, um so miteinander in Anlage zu gelangen.

6. Ein oberflächenmontierter Verbinder nach Anspruch 5, dadurch gekennzeichnet, daß mindestens eine der beiden miteinander in Anlage zu gelangenden Führungen ein Stiel mit einem gespaltenen Schlitz (23A) und einem Querschnitt eines eingekerbten Kreises ist.

7. Ein oberflächenmontierter Verbinder nach Anspruch 6 oder Anspruch 7, zusammengebaut mit einer Leiterplatte (30) mit Löchern oder Einkerbungen (32), wobei die Führungen (13, 23) über die Löcher oder Einkerbungen (32) miteinander in Anlage stehen.

8. Ein oberflächenmontierter Verbinder nach irgendeinem der Ansprüche 1 bis 6, zusammengebaut mit einer Leiterplatte (30), wobei Abschnitte der Gehäuse (10, 20) angrenzend an die Kontaktabschnitte (12A, 22A) der Kontakte (12, 22) jedes Gehäuses (10, 20) die Leiterplatte zusammenklemmen und die Kupplungsabschnitte (11, 21) in entgegengesetzten Richtungen von einer Seitenfläche der Leiterplatte ausgehen.

## Revendications

1. Un connecteur à monter sur une surface pour venir s'engager sur une carte de circuits imprimés, connecteur qui comprend une paire de logements allongés (10, 20) qui peuvent venir s'engager l'un avec l'autre afin de former un canal de manière à recevoir, en service, une partie de bord d'une carte de circuits imprimés, et une série de contacts (12, 22) s'étendant depuis une première surface latérale d'au moins l'un desdits logements (10, 20) selon une direction longitudinale de ladite première surface latérale, lesdits contacts (12, 22) comprenant des parties de contact (12A, 22A) pour venir en contact en service, lorsque les logements sont engagés l'un dans l'autre, avec des parties conductrices d'au moins une surface d'une carte de circuits imprimés, les logements (10, 20) comprenant des parties engagées (11, 21) constituées par une série de saillies conjuguées (11A, 21A), formées le long de la direction longitudinale des logements (10, 20).

2. Un connecteur à monter sur une surface selon la revendication 1, caractérisé en ce que les logements (10, 20) de ladite paire sont de forme identique.

3. Un connecteur à monter sur une surface selon la revendication 1 ou la revendication 2, caractérisé en ce que lesdites parties engagées (11, 21) desdits logements et lesdits contacts (12, 22) sont décalés les uns par rapport aux autres le long de la direction longitudinale desdits logements et sont situés à des positions à niveaux différents.

4. Un connecteur à monter sur une surface selon l'une quelconque des revendications 1 à 3, caractérisé en ce que lesdits contacts comprennent des parties de raccordement (12B et 22B) qui s'étendent à travers ledit logement et s'étendent à partir de celui-ci sur un côté opposé auxdites parties de contact (12A, 22A), desdits contacts (12, 22).

5. Un connecteur à monter sur une surface selon l'une quelconque des revendications 1 à 4, caractérisé en ce que ladite paire de logements comprend des guides (13 et 23) s'étendant depuis les côtés opposés desdits logements de façon à s'engager les uns avec les autres.

6. Un connecteur à monter sur une surface selon la revendication 5, caractérisé en ce qu'au moins l'une desdites paires de guides qui doivent venir s'engager les uns dans les autres, comprend un montant comportant une encoche fendue (23A) et une section transversale d'un cercle comportant des encoches.

7. Un connecteur à monter sur une surface selon la revendication 6 ou la revendication 7, assemblé à une carte de circuits imprimés (30) dans laquelle sont ménagés des trous ou encoches (32), dans lequel lesdits guides (13, 23) sont engagés les uns avec les autres à travers lesdits trous ou encoches (32).

8. Un connecteur à monter sur une surface selon l'une quelconque des revendications 1 à 6, assemblé à une carte de circuit imprimé (30), dans lequel des parties desdits logements (10, 20) adjacentes auxdites parties de contact (12A, 22A) desdits contacts (12, 22) de chaque logement (10, 20) prennent en sandwich ladite carte de circuit imprimé, et lesdites parties de contact engagées (11, 21) s'étendent dans des directions opposées à partir d'une première surface latérale de ladite carte de circuit imprimé.
